(19) Europäisches Patentamt
European Patent Office
Office européen des brevets

(11) **EP 1 018 802 B1**

(12) **EUROPÄISCHE PATENTSCHRIFT**

(45) Veröffentlichungstag und Bekanntmachung des Hinweises auf die Patenterteilung:
**07.04.2010 Patentblatt 2010/14**

(51) Int Cl.:
*H03F 3/72* (2006.01)   *H03F 1/26* (2006.01)
*H03F 3/45* (2006.01)   *H03M 1/06* (2006.01)

(21) Anmeldenummer: **99118943.2**

(22) Anmeldetag: **25.09.1999**

(54) **Integrierter Operationsverstärker für einen Analog-Digital-Wandler**

Integrated operational amplifier for an analog to digital converter

Amplificateur opérationnel intégré pour un convertisseur analogique / numérique

(84) Benannte Vertragsstaaten:
**DE FR GB IT NL**

(30) Priorität: **09.01.1999 DE 19900558**

(43) Veröffentlichungstag der Anmeldung:
**12.07.2000 Patentblatt 2000/28**

(73) Patentinhaber: **Micronas GmbH**
**79108 Freiburg i. Br. (DE)**

(72) Erfinder: **Greitschus, Norbert**
**79346 Endingen (DE)**

(74) Vertreter: **Patentanwälte**
**Westphal, Mussgnug & Partner**
**Am Riettor 5**
**78048 Villingen-Schwenningen (DE)**

(56) Entgegenhaltungen:
**US-A- 5 148 163**

• **LAUG O B: "A 100 A, 100 KHZ TRANSCONDUCTANCE AMPLIFIER" IEEE TRANSACTIONS ON INSTRUMENTATION AND MEASUREMENT, IEEE INC. NEW YORK, US, Bd. 45, Nr. 2, 1. April 1996 (1996-04-01), Seiten 440-444, XP000591411 ISSN: 0018-9456**
• **RIEDEL R J: "HIGH-THROUGHPUT AMPLIFIER AND ANALOG-TO-DIGITAL CONVERTER" HEWLETT-PACKARD JOURNAL, HEWLETT-PACKARD CO. PALO ALTO, US, Bd. 45, Nr. 5, 1. Oktober 1994 (1994-10-01), Seiten 16-20, XP000471151**

**Beschreibung**

Die vorliegende Erfindung betrifft einen integrierten Operationsverstärker für einen Analog-Digital-Wandler (AD-Wandler), der dazu dient, ein Nutzsignal vor der Digitalisierung durch den AD-Wandler zu verstärken. Ein integrierter Operationsverstärker für einen Analog-Digital-Wandler ist aus Dokument US-A-5,148,163 bekannt.

Ein System mit einem AD-Wandler hat mitunter den Nachteil, daß sich bei einer zu geringen Auflösung die Quantisierung des Eingangssignals störend bemerkbar macht. Eine Auflösung von 8 Bit, bei der das am Eingang des AD-Wandlers anliegende Analogsignal auf einen von 256 unterschiedlichen, diskreten Werten am Ausgang des AD-Wandlers abgebildet wird, ist hinsichtlich der Genauigkeit ausreichend für'viele Anwendungen in der Bildverarbeitung. Allerdings kann diese Quantisierung im Bild sichtbar sein. Entsprechen die Analogwerte beispielsweise den Helligkeitswerten eines zeilenweise abgetasteten Bildes, bei dem sich die Helligkeit in horizontaler Richtung kontinuierlich ändert, so können aus dem digitalisierten Signal für das genannte Beispiel lediglich 256 unterschiedliche Helligkeitswerte rekonstruiert werden. Die Übergänge von einem zum nächsten Helligkweitswert erfolgen dabei in jeder Zeile an derselben Position, was das menschliche Auge als vertikalen Strich bzw. als sprunghafte Änderung der Helligkeit wahrnimmt.

Ein Ansatz zur Lösung dieses Problems ist in EP 0 838 903 A1 und EP 0 543 220 A1 beschrieben und sieht vor, dem Nutzsignal vor der Quantisierung ein Rauschsignal zu überlagern. Vorteilhafterweise ist dieses Rauschsignal gefärbt. Der größte Teil der Rauschleistung liegt oberhalb des Frequenzbereichs des Nutzsignals. Dieses Vorgehen verringert zwar den Signal-Rausch-Abstand des Systems macht sich jedoch für den Betrachter des aus dem digitalisierten Signal gewonnenen Bildes positiv bemerkbar. Jedem zu digitalisierenden Analogwert wird dabei ein Zufallssignals auf unterschiedliche diskrete Werte am Ausgang des AD-Wandlers abgebildet werden können. Die einer Spalte des abgetasteten Bildes entstammenden Helligkeitswerte werden so nicht notwendigerweise auf dieselben diskreten Werte abgebildet. Insbesondere Analogsignale, die im Grenzbereich zwischen zwei Quantisierungsstufen liegen, werden dadurch zufällig auf die höhere oder niedrigere Quantisierungsstufe abgebildet. Bei dem aus den digitalisierten Werten gewonnenen Bild kann der Wechsel von einer Helligkeitsstufe zur nächsten in unterschiedlichen Zeilen an unterschiedlichen Positionen, die sich um einige Bildpunkte unterscheiden, erfolgen, so daß der Helligkeitswechsel vom menschlichen Auge nicht mehr als Sprung empfunden wird.

Das Rauschsignal, dessen mittlere Leistung konstant sein soll, wird bei bekannten derartigen Verstärkern durch ein Widerstandsnetzwerk oder einen zusätzlichen Addier-Verstärker erzeugt, die dem Ausgang des Verstärkers nach- und dem Eingang des AD-Wandlers vorgeschaltet sind. Das Widerstandsnetzwerk hat dabei insbesondere den Nachteil, daß es den Ausgangswiderstand des Verstärkers erhöht, während der AD-Wandler einen geringen Ausgangswiderstand des vorgeschalteten Verstärkers erfordert, da sonst bei hohen Frequenzen des Eingangssignals die Fehler des AD-Wandlers zunehmen. Der Nachteil des zusätzlichen Addier-Verstärkers besteht darin, daß sich die Stromaufnahme und der Flächenverbrauch des Systems erhöht.

Bei weiterhin bekannten derartigen Verstärkern wird das Rauschsignal dem Eingangssignal vor der Verstärkung durch den Verstärker überlagert und ebenfalls verstärkt. Da die Verstärkung des Verstärkers variabel sein soll, die mittlere Leistung des dem AD-Wandler zugeführten Rauschsignals aber konstant bleiben soll, erfordert diese Lösung, daß das Rauschsignal stets an die jeweilige Verstärkung angepaßt wird.

Aufgabe der vorliegenden Erfindung ist es, einen verbesserten Verstärker für einen Analog-Digital-Wandler zur Verfügung zu stellen, dessen Verstärkung einstellbar ist, an dessen Ausgang ein Rauschsignal mit konstanter mittlerer Leistung anliegt und bei dem sich insbesondere die oben genannten Nachteile nicht ergeben.

Diese Aufgabe wird durch einen integrierten Operationsverstärker gemäß der Merkmale des Patentanspruchs 1 gelöst.

Danach weist der Verstärker eine erste Verstärkerstufe auf mit einer ersten Eingangsklemme, an der ein Eingangssignal anlegbar ist, und mit einer Ausgangsklemme, die direkt an eine Eingangsklemme einer nachgeschalteten zweiten Verstärkerstufe angeschlossen ist. An einer Ausgangsklemme der zweiten Verstärkerstufe steht dabei ein Ausgangssignal zur Verfügung welches über einen Rückkopplungszweig, der ein passives Netzwerk aufweist, an eine zweite Eingangsklemme der ersten Verstärkerstufe zurückgekoppelt ist. Die Verstärkung dieser Kombination aus erster und zweiter Verstärkerstufe mit Rückkopplung hängt dabei im wesentlichen von den Parametern des Netzwerks im Rückkopplungszweig ab. Der erfindungsgemäßeintegrierte Operationsverstärker weist weiterhin eine Rauschquelle auf, die parallel zu der ersten Verstärkerstufe an die Eingangsklemme der zweiten Verstärkerstufe angeschlossen ist. Der Pegel eines Signalanteils am Ausgang der zweiten Verstärkerstufe, der durch ein Ausgangssignal der Rauschquelle hervorgerufen wird, hängt dabei von den Parametern des Netzwerks im Rückkopplungszweig und von der Verstärkung der ersten Verstärkerstufe ab. Diese Größen sind variabel und so aufeinander einstellbar, daß der Pegel dieses durch die Rauschquelle am Ausgang hervorgerufenen Signalanteils unabhängig von der Verstärkung des Verstärkers ist.

Vorteilhafte Ausgestaltungen der Erfindung sind Gegenstand der Unteransprüche.

Eine Ausführungsform der Erfindung sieht vor, das passive Netzwerk des Rückkopplungszweiges als Spannungsteiler auszubilden, wobei ein Abgriff des Spannungsteilers an die zweite Eingangsklemme der ersten Verstärkerstufe angeschlossen ist. An der zweiten Eingangsklemme der ersten Verstärkerstufe liegt dann ein k-faches des an der Ausgangsklemme der zweiten Verstärkerstufe anliegenden Ausgangssignals an, wobei der Rückkopplungsfaktor k von dem Teilerverhältnis des Spannungsteilers abhängt und die Gesamtverstärkung der aus erster und zweiter Verstärkerstufe gebildeten Teilkomponente des erfindungsgemäßen Verstärkers beeinflußt.

Weiterhin ist vorgesehen, daß eine Verstärkung der ersten Verstärkerstufe abhängig von dem Rückkopplungsfaktor k einstellbar ist. Dies erfolgt gemäß einer weiteren Ausführungsform der Erfindung dadurch, daß die erste Verstärkerstufe mehrere parallel geschaltete Verstärker aufweist, die abhängig von dem Rückkopplungsfaktor k zuschaltbar sind. Die Verstärker der ersten Verstärkerstufe sind dabei vorzugsweise als Differenzverstärker ausgebildet.

Eine weitere Ausführungsform der Erfindung sieht vor, daß die Rauschquelle einen Differenzverstärker mit einer ersten und zweiten Eingangskemme aufweist, zwischen denen ein Rauschsignal anlegbar ist.

Vorteilhafte Ausgestaltungen der Erfindung werden nachfolgend in Figuren anhand von Ausführungsbeispielen näher erläutert. Es zeigen:

Figur 1: eine erste Ausführungsform des erfindungsgemäßen in- tegrierten Operationsverstärkers;

Figur 2: eine zweite Ausführungsform des erfindungsgemäßen in- tegrierten Operationsverstärkers;

Figur 3: Verstärker gemäß Figur 2 mit Detaildarstellung der ersten Verstärkerstufe und der Rauschquelle.

In den Figuren bezeichnen, sofern nicht anders angegeben, gleiche Bezugszeichen gleiche Bauteile mit gleicher Bedeutung.

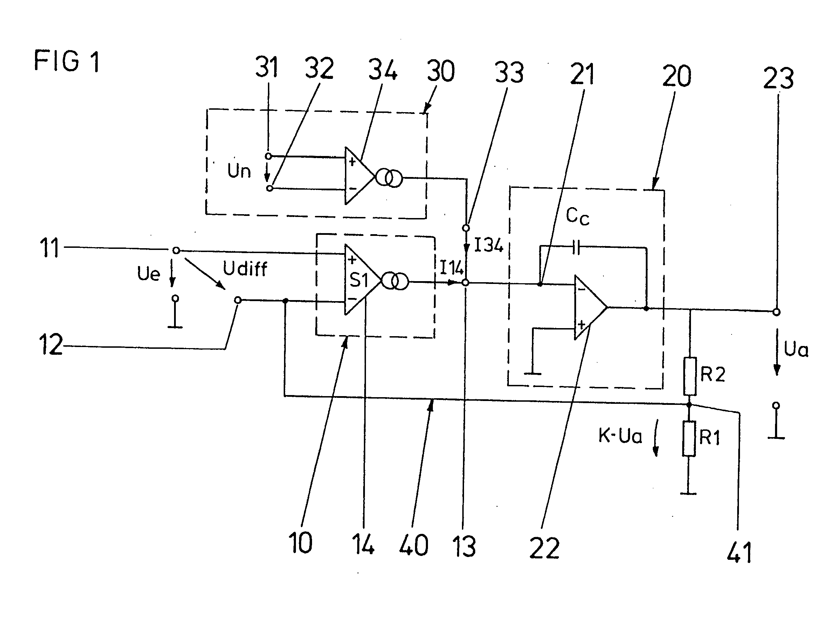

Figur 1 zeigt ein erstes Ausführungsbeispiel des erfindungsgemäßen integrierten Operationsverstärkers mit einer ersten Verstärkerstufe 10, einer der ersten Verstärkerstufe 10 nachgeschalteten zweiten Verstärkerstufe 20, einer Rauschquelle 30 und einem Rückkopplungszweig 40. Die erste Verstärkerstufe 10 besitzt eine erste Eingangsklemme 11, an der ein Eingangssignal Ue als Spannung gegen Bezugspotential anliegt. Eine Ausgangsklemme 13 der ersten Verstärkerstufe 10 ist an eine Eingangsklemme 21 der zweiten Verstärkerstufe 20 angeschlossen, wobei an einer Ausgangsklemme 23 der zweiten Verstärkerstufe 20 ein Ausgangssignal Ua abgreifbar ist, welches einem AD-Wandler zugeführt werden kann.

Das Ausgangssignal Ua ist über einen Rückkopplungszweig 40 an eine zweite Eingangsklemme 12 der ersten Verstärkerstufe 10 zurückgekoppelt. Der Rückkopplungszweig 40 weist einen Spannungsteiler mit einem ersten und zweiten in Reihe geschalteten Widerstand R1, R2 auf, wobei ein den Widerständen R1, R2 gemeinsamer Knoten 41 an die zweite Eingangsklemme 12 der ersten Verstärkerstufe 10 angeschlossen ist. Das an dieser zweiten Eingangsklemme 12 anliegende Signal beträgt ein k-faches des Ausgangssignals Ua, wobei sich der sogenannte Rückkopplungsfaktor k gemäß $k=R1/(R1+R2)$ aus den Widerstandswerten der Widerstände R1, R2 des Spannungsteilers ergibt.

Die erste Verstärkerstufe 10 weist in dem dargestellten Ausführungsbeispiel einen Differenzverstärker 14 auf, der als sogenannter Transconductance-Verstärker ausgebildet ist. Am Ausgang des Differenzverstärkers 14 ist dabei ein Strom I14 eingeprägt, der von der Differenz Udiff der Signale Ue und k·Ua an den Eingangsklemmen 11, 12 der ersten Verstärkerstufe 10 abhängt. Wird der Verstärker 14 in einem Arbeitspunkt innerhalb seiner Aussteuerungsgrenzen betrieben, wirken sich kleine Änderungen ΔUdiff dieser Differenz Udiff der Signale Ue und k·Ua gemäß $\Delta I14=S1\cdot\Delta Udiff$ auf Änderungen des Stromes I14 aus. S1 bezeichnet dabei die Steilheit des Verstärkers 14 der ersten Verstärkerstufe 10.

Die zweite Verstärkerstufe weist einen Verstärker 22 auf, wobei zwischen die Ausgangsklemme 23 und die Eingangsklemme 12 des Verstärkers 22 eine als Millerkapazität bezeichnete Kapazität $C_c$ zur frequenzabhängigen Spannungsgegenkopplung geschaltet ist. Eine weitere Eingangsklemme des Verstärkers 22 ist an Bezugspotential angeschlossen.

Die dargestellte Verschaltung der ersten und zweiten Verstärkerstufe entspricht dem inneren Aufbau eines Operationsverstärkers, wie er beispielsweise aus Tietze/Schenk: "Halbleiterschaltungstechnik", 9. Auflage, Springer Verlag, S. 140 bekannt ist.

Die Kombination aus erster und zweiter Verstärkerstufe 10, 20 besitzt eine von der Frequenz des Eingangssignals abhängige und damit komplexwertige Gesamtverstärkung $\underline{V}$ wobei sich für Änderungen ΔUdiff der Differenz Udiff der Eingangssignale folgende Änderung ΔUa des Ausgangssignals Ua ergibt:

$$\Delta Ua = \underline{V}\cdot\Delta Udiff, \qquad\qquad (1)$$

sofern sich das Ausgangssignal noch innerhalb der Aussteuergrenzen befindet. Für den rückgekoppelten Verstärker gilt:

$$\Delta Ua/\Delta Ue \;=\; \underline{V}\;/(1+k\cdot\underline{V}). \qquad\qquad (2)$$

Der Betrag der Verstärkung $\underline{V}$ beträgt üblicherweise zwischen $10^4$ und $10^5$, so daß für die Verstärkung kleiner Aussteuerungen $\Delta Ua/\Delta Ue = 1/k$ angenommen werden kann. Wird der Verstärker innerhalb seiner Aussteuergrenzen betrieben, so gilt auch $Ua/Ue=1/k$, sofern die Kreisfrequenz des Eingangssignals Ue geringer ist als die Bandbreite $\omega_{BW}$ des Verstärkers. Die Bandbreite $\omega_{BW}$ ist dabei gegeben durch

$$\omega_{BW} \;=\; k\cdot\omega_{T}, \qquad\qquad (3)$$

wobei $\omega_T$ die Transitfrequenz des Verstärkers bezeichnet, die sich für einen Verstärker mit Differenzverstärker als erster Verstärkerstufe 10 und millerkompensierter zweiter Verstärkerstufe 20 wie folgt berechnet:

$$\omega_{T} \;=\; S1/C_{c}. \qquad\qquad (4)$$

Die Rauschquelle 30 weist in dem dargestellten Ausführungsbeispiel ebenfalls einen als Transconductance-Verstärker ausgebildeten Differenzverstärker 34 auf, wobei zwischen Eingangsklemmen 31, 32 des Differenzverstärkers 34 ein Rauschsignal Un anliegt. An einem Ausgang des Differenzverstärkers 34 ist dabei ein Strom I34 eingeprägt, für den gilt:

$$\Delta I34 \;=\; Sn\cdot\Delta Un, \qquad\qquad (5)$$

wenn der Verstärker 34 innerhalb seiner Aussteuergrenzen betrieben wird, wobei Sn die Steilheit des Differenzverstärkers 34 bezeichnet.
Änderungen $\Delta Un$ des Rauschsignals Un bewirken dabei Änderungen $\Delta Ua$ des Ausgangssignals Ua gemäß

$$\Delta Ua \;=\; Sn/S1\cdot\Delta Un\cdot 1/k. \qquad\qquad (6)$$

Dies ergibt sich daraus, daß bei konstant angenommenem Eingangssignal Ue Änderungen des Rauschsignals Un eine Änderungen $\Delta Ua$ des Ausgangssignals Ua bewirken, die über den Rückkopplungszweig 40 an der zweiten Eingangsklemme 12 eine Änderung $k\cdot\Delta Ua$ des zurückgekoppelten Signals bewirkt. Hieraus resultiert eine Änderung $\Delta I14$ des am Ausgang des Differenzverstärkers eingeprägten Stromes I14. Diese Änderung des Stromes I14 wirkt der Änderung $\Delta I34$ des Stromes I34 entgegen, wobei sich ein Gleichgewicht einstellt, wenn $\Delta I34 = \Delta I14$ gilt.
Setzt man $\Delta I34=Sn\cdot\Delta Un$ und $\Delta I14=S1\cdot k\cdot\Delta Ua$ und löst nach $\Delta Ua$ auf, so ergibt sich für die Änderungen des Ausgangssignals Ua abhängig von dem Rauschsignal Un die oben genannte Beziehung (6).
Zusammenfassend wirken sich Aussteuerungen $\Delta Ue$ des Eingangssignals Ue und $\Delta Un$ des Rauschsignals Un wie folgt auf Aussteuerungen $\Delta Ua$ des Ausgangssignals Ua aus:

$$\Delta Ua \;=\; (\Delta Ue \;+\; Sn/S1\cdot\Delta Un)/k. \qquad\qquad (7)$$

Der durch das Eingangssignal Ue bewirkte Signalanteil ist dabei lediglich von dem Rückkopplungsfaktor k, und damit von den Parametern des passiven Netzwerks des Rückkopplungszweigs 40 abhängig, während der durch das Rauschsignal Un bewirkte Signalanteil von dem Rückkopplungsfaktor k und der Steilheit S1 der ersten Verstärkerstufe 10 abhängt. Um eine von der Verstärkung 1/k des Nutzsignals Ue unabhängige Verstärkung des Rauschsignals zu bewirken, sieht die Erfindung vor, die Steilheit der ersten Verstärkerstufe 10 abhängig von dem Rückkopplungsfaktor k variierbar zu gestalten. Der Rückkopplungsfaktor k kann durch variieren der Widerstände R1, R2 verändert werden, die als Potentiometer ausgebildet sind.

Die Steilheit der ersten Verstärkerstufe beträgt dabei vorzugsweise

$$S1 = \omega_{BW} \cdot C_c / k.$$ (8)

Hierdurch ist des weiteren gewährleistet, daß die Bandbreite $\omega_{BW}$ des Verstärkers, also der Frequenzbereich, innerhalb dessen die Verstärkung des Eingangssignals Ue konstant ist, unabhängig von der über den Rückkopplungsfaktor eingestellten Verstärkung ist.

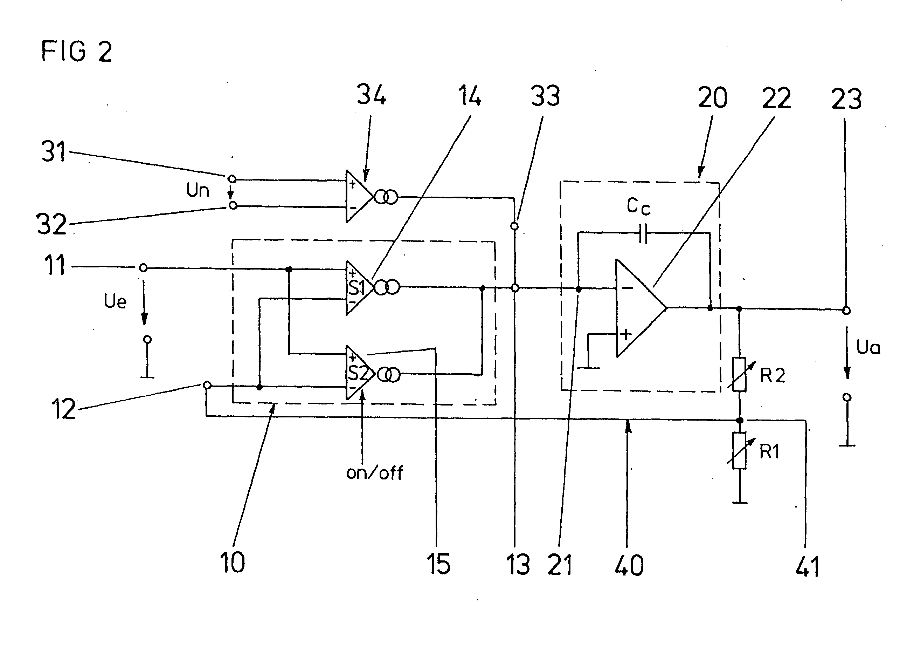

Eine Ausführung der Erfindung sieht vor, für die erste Verstärkerstufe 10 mehrere Differenzverstärker 14, 15 parallel zu schalten, wie dies in Figur 2 für die Verwendung zweier Differenzverstärker 14, 15 dargestellt ist. Jeweils eine Eingangsklemme der Differenzverstärker 14, 15, in dem dargestellten Beispiel die nicht-invertierende Eingangsklemme, ist dabei an die erste Eingangsklemme 11 und jeweils eine Eingangsklemme der Differenzverstärker 14, 15 ist an die zweite Eingangsklemme 12 der ersten Verstärkerstufe 10 angeschlossen. Ausgänge der beiden Differenzverstärker 14, 15 sind an der Ausgangsklemme 13 der ersten Verstärkerstufe 10 zusammengeführt. Jeder der beiden Differenzverstärker 14, 15 ist als Transconductance-Verstärker ausgebildet und liefert an seinem Ausgang einen von der Differenz der Eingangssignale Ue und k·Ua abhängigen Strom. Die jeweiligen Steilheiten S1, S2 der Differenzverstärker 14, 15 addieren sich dabei zu der Gesamtsteilheit S der ersten Verstärkerstufe, wobei gilt:

$$S = S1 + S2.$$ (9)

Entsprechendes gilt bei Parallelschaltung weiterer Differenzverstärker. Wie in Figur 2 durch einen mit on/off bezeichnete Ansteuerleitung dargestellt ist, ist der Differenzverstärker 15 anschaltbar oder abschaltbar, um die Steilheit der ersten Verstärkerstufe bei einer Änderung des Rückkopplungsfaktors k ändern zu können und dadurch eine von der Verstärkung 1/k des Nutzsignals Ue unabhängige Verstärkung des Rauschsignals Un sowie eine konstante Bandbreite $\omega_{BW}$ zu erreichen. Im vorliegenden Fall sind zwei unterschiedliche Steilheiten S=S1 und S=S1+S2 einstellbar, dementsprechend sind zwei Verstärkungen 1/k möglich, die sich gemäß Beziehung (8) berechnen und für die die Verstärkung des Rauschsignals Un unabhängig von der Verstärkung des Eingangssignals Ue ist. Ist auch der Differenzverstärker 14 separat schaltbar, und ist S1 ungleich S2, sind für das in Figur 2 dargestellte Ausführungsbeispiel drei unterschiedliche Verstärkungen möglich, für die die genannten Zusammenhänge gelten. Die Anzahl der möglichen Verstärkungen, für die die Verstärkung des Rauschsignals Un von der Gesamtverstärkung unabhängig ist, steigt dabei mit zunehmender Anzahl der parallel geschalteten Differenzverstärker für die erste Verstärkerstufe 10.

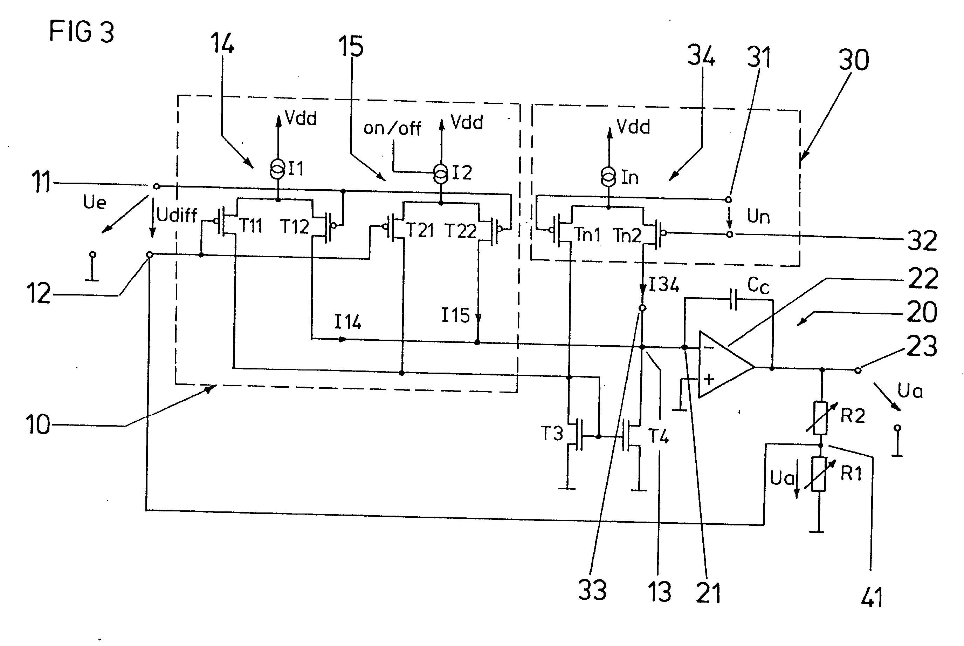

Figur 3 zeigt das in Figur 2 dargestellte Ausführungsbeispiel des erfindungsgemäßen Verstärkers, wobei in Figur 3 ein Beispiel für die schaltungstechnische Realisierung der ersten Verstärkerstufe 10 und der Rauschquelle 30 dargestellt ist. Die Differenzverstärker für die erste Verstärkerstufe 10 und die Rauschquelle 30 werden dabei jeweils durch eine Stromquelle I1; I2; In und ein Transistorpaar T11, T12; T21, T22; T1n, T2n gebildet, denen ein aus zwei Transistoren T3, T4 gebildeter Stromspiegel gemeinsam ist. Die Transistoren eines Transistorpaares sind dabei vorzugsweise identisch. Die Transistoren T11, T12, T21, T22, Tn1, Tn2 sind in dem dargestellten Ausführungsbeispiel als p-Kanal-Transistoren, die Transistoren T3, T4 des Stromspiegels als n-Kanal-Transistoren ausgebildet.

Die Transistoren T11, T12; T21, T22; Tn1, Tn2 sind mit ihrer Laststrecke in Reihe zu der jeweiligen Stromquelle I1, I2, In geschaltet, wobei die Stromquellen I1, I2, In an ein Versorgungspotential Vdd angeschlossen sind. Jeweils einer der Transistoren T11, T21, Tn1 der Differenzverstärker 14, 15, 34 ist dabei in Reihe zu dem Transistor T3 des Stromspiegels geschaltet, der andere Transistor T12, T22, Tn2 der Differenzverstärker 14, 15, 34 ist in Reihe zu dem Transistor T4 des Stromspiegels geschaltet.

Die Gateanschlüsse der Transistoren T11, T21 der Differenzverstärker 14, 15 sind an die erste Eingangsklemme 11, die Gateanschlüsse der Transistoren T12, T22 sind an die zweite Eingangsklemme 12 der ersten Verstärkerstufe 10 angeschlossen. Die Differenzverstärker 14, 15 liefern einen Strom I14, I15 an die Ausgangsklemme 13 bzw. die Eingangsklemme 21 der zweiten Verstärkerstufe 20, der von der Differenz der zwischen den Eingangsklemmen 11, 12 anliegenden Signale Ue und k·Ua abhängt und jeweils maximal dem durch die Stromquellen I1, I2 gelieferten Strom entspricht. Die Steilheiten S1, S2 der Differenzverstärker 14, 15 sind abhängig von den Steilheiten der Transistoren T11, T12, T21, T22 für den jeweils durch die Stromquellen I1, I2 gelieferten Strom.

Die Gateanschlüsse der Transistoren Tn1, Tn2 der Rauschquelle 34 sind an die erste bzw. zweite Eingangsklemme 31, 32 der Rauschquelle angeschlossen, an der das Rauschsignal Un anliegt.

Die Stromquelle I2 des Differenzverstärkers ist in dem dargestellten Ausführungsbeispiel zu- bzw. abschaltbar ausgebildet, um den Differenzverstärker zur Variierung der Gesamtsteilheit S der ersten Verstärkerstufe 10 ein- bzw.

ausschalten zu können.

Die zweite Verstärkerstufe ist in allen Ausführungsbeispielen als invertierender Verstärker verschaltet. Der Verwendung eines nicht-invertierenden Verstärkers steht jedoch für ein Funktionieren des erfindungsgemäßen Verstärkers nichts entgegen.

Bezugszeichenliste

| | |
|---|---|
| 10 | erste Verstärkerstufe |
| 11 | erste Eingangsklemme der ersten Verstärkerstufe |
| 12 | zweite Eingangsklemme der ersten Verstärkerstufe |
| 13 | Ausgangsklemme der ersten Verstärkerstufe |
| 14, 15 | Differenzverstärker |

| | |
|---|---|
| 20 | zweite Verstärkerstufe |
| 21 | Eingangsklemme der zweiten Verstärkerstufe |
| 22 | Verstärker |
| 23 | Ausgangsklemme |

| | |
|---|---|
| 30 | Rauschquelle |
| 31 | erste Eingangsklemme der Rauschquelle |
| 32 | zweite Eingangsklemme der Rauschquelle |
| 33 | Ausgangsklemme der Rauschquelle |
| 34 | Differenzverstärker |

| | |
|---|---|
| 40 | Rückkopplungszweig |
| 41 | Abgriff |

| | |
|---|---|
| $C_c$ | Millerkapazität |
| I14, I15, I34 | Ströme |
| R1, R2 | veränderliche Widerstände |
| T11, T12, T21, T22, Tn1, Tn2, T3, T4 | Transistoren |
| Ua | Ausgangssignal |
| Udiff | Differenzsignal |
| Ue | Eingangssignal |
| Un | Rauschsignal |
| Vdd | Versorgungspotential |

**Patentansprüche**

**1.** Integrierter Operationsverstärker für einen Analog-Digital-Wandler der folgende Merkmale aufweist:

> - eine erste Verstärkerstufe (10) mit einer ersten Eingangsklemme (11) zum Zuführen eines Verstärkereingangssignals (Ue), einer zweiten Eingangsklemme (12) und einer Ausgangsklemme (13);
> - eine zweite Verstärkerstufe (20) mit einer Eingangsklemme (21),
> und mit einer Ausgangsklemme (23) an der ein Ausgangssignal (Ua) abgreifbar ist;
> - einen Rückkopplungszweig (40) zwischen der Ausgangsklemme (23) der zweiten Verstärkerstufe (20) und der zweiten Eingangsklemme (12) der ersten Verstärkerstufe (10), wobei der Rückkopplungszweig (40) eine passives Netzwerk (R1, R2, 41) aufweist, wobei ein am Ausgang des Rückkopplungszweiges anliegendes Signals ein k-faches des Ausgangssignals (Ua) beträgt, wobei $0 \leq k \leq 1$ ist;
> - eine Rauschquelle (30) mit einer Ausgangsklemme (33), die an die Eingangsklemme (21) der zweiten Verstärkerstufe (20) angeschlossen ist, **dadurch gekennzeichnet, dass**

die Eingangsklemme (21) der zweiten Verstärkerstufe (20) an die Ausgangsklemme (13) der ersten Verstärkerstufe (10) unmittelbar angeschlossen ist, und eine Verstärkung (S1, S) der ersten Verstärkerstufe (10) abhängig von dem Rückkopplungsfaktor k einstellbar ist, sodass die Verstärkung des Rauschsignals unabhängig von der Verstärkung des Eingangssignals ist.

**2.** Integrierter Operationsverstärker nach Anspruch 1, **dadurch gekennzeichnet, dass** das passive Netzwerk ein Spannungsteiler (R1, R2, 41) ist, wobei ein Abgriff (41) des Spannungsteilers (R1, R2, 41) an die zweite Eingangsklemme (12) der ersten Verstärkerstufe (10) angeschlossen ist.

**3.** Integrierter Operationsverstärker nach einem der vorangehenden Ansprüche,
**dadurch gekennzeichnet, dass**
die erste Verstärkerstufe (10) als Differenzverstärkerstufe ausgebildet ist.

**4.** Integrierter Operationsverstärker nach einem der vorangehenden Ansprüche,
**dadurch gekennzeichnet, dass**
die erste Verstärkerstufe (10) einen ersten Differenzverstärker (14) aufweist, der an die Eingangsklemmen (11, 12) und die Ausgangsklemme (13) angeschlossen ist.

**5.** Integrierter Operationsverstärker nach Anspruch 4, **dadurch gekennzeichnet, dass**
die erste Verstärkerstufe wenigstens einen weiteren Differenzverstärker (15) aufweist, der parallel zu dem ersten Differenzverstärker (14) an die Eingangsklemmen (11, 12) und die Ausgangsklemme (13) angeschlossen ist.

**6.** Integrierter Operationsverstärker nach einem der vorangehenden Ansprüche,
**dadurch gekennzeichnet, dass**
der wenigstens eine weitere Differenzverstärker (15) abhängig von dem Rückkopplungsfaktor k zuschaltbar ist.

**7.** Integrierter Operationsverstärker nach einem der Ansprüche 4 bis 6,
**dadurch gekennzeichnet, dass**
die Differenzverstärker (14, 15) als Transconductance-Verstärker ausgebildet sind.

**8.** Integrierter Operationsverstärker nach einem der vorangehenden Ansprüche,
**dadurch gekennzeichnet, dass**
die Rauschquelle (30) einen Differenzverstärker (34) mit einer ersten und zweiten Eingangsklemme (31, 32) aufweist, zwischen denen eine Rauschsignal (Un) anlegbar ist.

**9.** Integrierter Operationsverstärker nach Anspruch 8,
**dadurch gekenntzeichnet**, **dass**
der Differenzverstärker (34) als Transconductance-Verstärker ausgebildet ist.

**10.** Integrierter Operationsverstärker nach einem der vorangehenden Ansprüche,
**dadurch gekennzeichnet, dass**
die zweite Verstärkerstufe (20) einen Verstärker (22) aufweist, bei dem eine Kapazität (Cc) zwischen die Ausgangsklemme (23) und die Eingangsklemme (21) geschaltet ist

**11.** Integrierter Operationsverstärker nach einem der vorangehenden Ansprüche,
**dadurch gekennzeichnet, dass**
für die Steilheit S der ersten Verstärkerstufe $S=\omega_{BW}\cdot Cc/k$ gilt, wobei $\omega_{BW}$ die Bandbreite des Verstärkers ist.

**Claims**

**1.** Integrated operational amplifier for an analog to digital converter, which has the following features:

- a first amplifier stage (10) comprising a first input terminal (11) for supplying an amplifier input signal (Ue), a second input terminal (12) and an output terminal (13);
- a second amplifier stage (20) comprising an input terminal (21) and an output terminal (23) at which an output signal (Ua) can be tapped;
- a feedback path (40) between the output terminal (23) of the second amplifier stage (20) and the second input terminal (12) of the first amplifier stage (10), wherein the feedback path (40) comprises a passive network (R1, R2, 41), wherein a signal applied to the output of the feedback path is a k-fold multiple of the output signal (Ua), wherein $0 \leq k \leq 1$;
- a noise source (30) comprising an output terminal (33) which is connected to the input terminal (21) of the second amplifier stage (20), **characterized in that**

the input terminal (21) of the second amplifier stage (20) is directly connected to the output terminal (13) of the first amplifier stage (10), and an amplification (S1, S) of the first amplifier stage (10) is adjustable as a function of the feedback factor k, so that the amplification of the noise signal is dependent on the amplification of the input signal.

2.  Integrated operational amplifier according to claim 1, **characterized in that** the passive network is a voltage divider (R1, R2, 41), wherein a tap (41) of the voltage divider (R1, R2, 41) is connected to the second input terminal (12) of the first amplifier stage (10).

3.  Integrated operational amplifier according to one of the preceding claims, **characterized in that** the first amplifier stage (10) is configured as a differential amplifier stage.

4.  Integrated operational amplifier according to one of the preceding claims, **characterized in that** the first amplifier stage (10) comprises a first differential amplifier (14) which is connected to the input terminals (11, 12) and the output terminal (13).

5.  Integrated operational amplifier according to claim 4, **characterized in that** the first amplifier stage comprises at least one further differential amplifier (15) which is connected to the input terminals (11, 12) and the output terminal (13) in parallel with the first differential amplifier (14).

6.  Integrated operational amplifier according to one of the preceding claims, **characterized in that** the at least one further differential amplifier (15) can be switched on as a function of the feedback factor k.

7.  Integrated operational amplifier according to one of claims 4 to 6, **characterized in that** the differential amplifiers (14, 15) are configured as transconductance amplifiers.

8.  Integrated operational amplifier according to one of the preceding claims, **characterized in that** the noise source (30) comprises a differential amplifier (34) having a first and second input terminal (31, 32), between which a noise signal (Un) can be applied.

9.  Integrated operational amplifier according to claim 8, **characterized in that** the differential amplifier (34) is configured as a transconductance amplifier.

10.  Integrated operational amplifier according to one of the preceding claims, **characterized in that** the second amplifier stage (20) comprises an amplifier (22) in which a capacitance (Cc) is connected between the output terminal (23) and the input terminal (21).

11.  Integrated operational amplifier according to one of the preceding claims, **characterized in that** $S = \omega_{BW} \cdot Cc/k$ applies for the gradient S of the first amplifier stage, wherein $\omega_{BW}$ is the bandwidth of the amplifier.

**Revendications**

1.  Amplificateur opérationnel intégré de convertisseur analogique/numérique ayant les caractéristiques suivantes :

    - un premier étage amplificateur (10) ayant une première borne d'entrée (11) pour recevoir un signal d'entrée d'amplificateur (Ue), une seconde borne d'entrée (12) et une borne de sortie (13),
    - un second étage amplificateur (20) ayant une borne d'entrée (21) et une borne de sortie (23) pour le signal de sortie (Ua),
    - une branche de réaction (40) entre la borne de sortie (23) du second étage amplificateur (20) et la seconde borne d'entrée (12) du premier étage amplificateur (10), la branche de réaction (40) ayant un réseau passif (R1, R2, 41), et un signal appliqué à la sortie de la branche de réaction représentant un multiple par (k) du signal de sortie (Ua), avec la relation $0 \leq k \leq 1$,

- une source de bruit (30) ayant une borne de sortie (33) reliée à la borne d'entrée (21) du second étage amplificateur (20),

**caractérisé en ce que**
la borne d'entrée (21) du second étage amplificateur (20) est reliée directement à la borne de sortie (13) du premier étage amplificateur (10), et l'amplification (S1, S) du premier étage amplificateur (10), est réglable en fonction du coefficient de réaction (k) pour que l'amplification du signal de bruit soit indépendante de l'amplification du signal d'entrée.

2. Amplificateur opérationnel selon la revendication 1,
**caractérisé en ce que**
le réseau passif est un diviseur de tension (R1, R2, 41), la prise (41) du diviseur de tension (R1, R2, 41) étant reliée à la seconde borne d'entrée (12) du premier étage amplificateur (10).

3. Amplificateur opérationnel selon l'une des revendications précédentes,
**caractérisé en ce que**
le premier étage amplificateur (10) est un étage amplificateur de différence.

4. Amplificateur opérationnel selon l'une des revendications précédentes,
**caractérisé en ce que**
le premier étage amplificateur (10) comporte un premier amplificateur de différence (14) relié aux bornes (11, 12) et à la borne de sortie (13).

5. Amplificateur opérationnel selon la revendication 4,
**caractérisé en ce que**
le premier étage amplificateur comporte au moins un autre amplificateur de différence (15) en parallèle au premier amplificateur de différence (14) sur les bornes d'entrée (11, 12) et la borne de sortie (13).

6. Amplificateur opérationnel selon l'une des revendications précédentes,
**caractérisé en ce qu'**
au moins un autre amplificateur de différence (15) peut se brancher en fonction du coefficient de réaction (k).

7. Amplificateur opérationnel selon l'une des revendications 4 à 6,
**caractérisé en ce que**
les amplificateurs de différence (14, 15) sont réalisés sous forme d'amplificateurs à transconductance.

8. Amplificateur opérationnel selon l'une des revendications précédentes,
**caractérisé en ce que**
la source de bruit (30) comporte un amplificateur de différence (34) ayant une première et une seconde borne d'entrée (31, 32) entre lesquelles est appliqué un signal de bruit (Un)

9. Amplificateur opérationnel selon la revendication 8,
**caractérisé en ce que**
l'amplificateur de différence (34) est un amplificateur à transconductance.

10. Amplificateur opérationnel selon l'une des revendications précédentes,
**caractérisé en ce que**
le second étage amplificateur (20) comporte un amplificateur (22) avec une capacité (Cc) branchée entre la borne de sortie (23) et la borne d'entrée (21).

11. Amplificateur opérationnel selon l'une des revendications précédentes,
**caractérisé en ce que**
la pente (S) du premier étage amplificateur est donnée par la formule $S = \omega_{Bw} \cdot Cc/k$, dans laquelle $\omega_{BW}$ représente la largeur de bande de l'amplificateur.

FIG 1

EP 1 018 802 B1

FIG 2

FIG 3

EP 1 018 802 B1

**IN DER BESCHREIBUNG AUFGEFÜHRTE DOKUMENTE**

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

**In der Beschreibung aufgeführte Patentdokumente**

- US 5148163 A
- EP 0838903 A1
- EP 0543220 A1